# DEMANDE DE BREVET EUROPEEN

(11) **EP 4 786 409 A1**
(43) Date de publication de la demande: **05.08.2026**
(21) Numéro de dépôt: 26154351.6
(22) Date de dépôt: 27.01.2026
(51) Int. Cl.: B81C 1/00

(54) **PROCÉDÉ DE FABRICATION DE MICROSTRUCTURES**

(30) Priorité: 31.01.2025 FR 2501017
(71) Demandeur: Commissariat à l'Energie Atomique et aux Energies Alternatives, 75015 Paris (FR)
(72) Inventeur: ABADIE, Quentin, 38054 GRENOBLE Cedex 09 (FR); MICHIT, Nicolas, 38054 GRENOBLE Cedex 09 (FR); PERNEL, Carole, 38054 GRENOBLE Cedex 09 (FR)
(74) Mandataire: Hautier IP

(57) **Abrégé**

L'invention concerne un procédé de fabrication de microstructures. On fournit tout d'abord un substrat (10), le substrat (10) présentant une face supérieure (11) s'étendant principalement parallèlement à un plan dit plan principal (XY). On réalise ensuite une gravure du substrat (10) à partir de sa face supérieure (11) de manière à former au moins un plot (100) dans le substrat (10), le plot (100) présentant, en projection dans le plan principal (XY), une première surface S100. On réalise ensuite une électro-gravure de l'au moins un plot (100) de sorte à former un pilier (1000), le pilier (1000) présentant, en projection dans le plan principal (XY), une deuxième surface S1000, avec S1000<S100.

## Description

### DOMAINE TECHNIQUE

La présente invention concerne le domaine de l'électronique, par exemple de la micro-électronique ou de l'opto-électronique. L'invention concerne tout particulièrement un procédé de fabrication de microstructures. La présente invention trouve des applications avantageuses dans de divers domaines, comme par exemple ceux de la micro-optique intégrée et des méta-surfaces optiques.

### ETAT DE LA TECHNIQUE

De très nombreux domaines techniques emploient aujourd'hui des structures de petites dimensions, typiquement de l'ordre de la centaine ou de quelques centaines de nanomètres. De telles structures sont par exemple utilisées en micro-optique intégrée ou pour réaliser des méta-surfaces présentant des propriétés optiques innovantes.

Les avancées dans ces domaines sont cependant freinées par les limites technologiques actuelles pour former des structures de dimensions encore inférieures. Les étapes de photolithographie et de gravure sont particulièrement limitantes lors de la fabrication des structures. En effet, il est complexe, avec les équipements actuellement existants et les résines employées lors des étapes de photolithographies, de former avec précision des structures présentant des dimensions très faibles, typiquement des dimensions inférieures à 100 nm. De telles dimensions ne peuvent être obtenues aujourd'hui qu'au moyen de procédés longs et difficilement industrialisables, comme la lithographie à faisceau d'électrons (couramment désignée « e-beam »), ou bien à l'aide d'équipements de lithographie avancés, comme des équipements de lithographie par immersion, très coûteux et disponibles uniquement pour des substrats de 300 mm de diamètre.

Il existe donc un besoin pour repousser les barrières actuellement existantes dans la formation de structures de très petites dimensions. De préférence, l'invention proposera une solution pour former des structures présentant des dimensions caractéristiques inférieures à 100 nm. De préférence, l'invention proposera une solution adaptée à des procédés non compatibles avec la lithographie par immersion, et notamment une solution compatible avec des substrats de 200 mm de diamètre. De préférence, l'invention proposera une solution à faible coût.

### RESUME

Pour atteindre cet objectif, un premier aspect de l'invention concerne un procédé de fabrication de microstructures comprenant les étapes suivantes :
- fournir un substrat, le substrat présentant une face supérieure s'étendant principalement parallèlement à un plan dit plan principal,
- réaliser une gravure anisotrope du substrat à partir de sa face supérieure et selon une direction verticale (Z) perpendiculaire au plan principal, de manière à former au moins un plot dans le substrat, le plot présentant, en projection dans le plan principal, une première surface S₁₀₀ et une hauteur H₁₀₀ selon la direction verticale,
- réaliser une électro-gravure de l'au moins un plot de sorte à former un pilier, le pilier présentant, en projection dans le plan principal, une deuxième surface S₁₀₀₀, avec S₁₀₀ₒ<S₁₀₀ et une hauteur selon la direction verticale égale à H₁₀₀.

En mettant en œuvre une étape d'électro-gravure après l'étape de gravure, il est possible d'atteindre des dimensions qui peuvent difficilement, voire ne peuvent pas, être obtenues à l'aide des équipements de gravure existants.

Il est à noter que les procédés de gravure en microélectronique ne servent habituellement pas à définir les dimensions d'un objet final. Ils ont plutôt vocation à structurer des couches en motifs qui ne forment pas les structures finales du procédé. La présente invention a donc recours à la gravure dans un objectif inhabituel.

Ainsi, la présente invention a recours à deux techniques de retrait de matière issus de deux domaines techniques différents pour repousser les barrières actuellement existantes dans la formation de structures de très petites dimensions. Alors que les équipements de gravure récents ont des limites en dimensions de quelques centaines de nanomètres, ou, pour les plus perfectionnés, de l'ordre de 100 nm - parfois 70 à 80 nm pour des équipements très avancées et uniquement accessibles aux technologies 300 mm -, le procédé selon l'invention permet de former des structures présentant des dimensions caractéristiques inférieures à 100 nm, typiquement de l'ordre de quelques dizaines de nanomètres, par exemple allant jusqu'à 10 nm. Le procédé selon l'invention permet d'atteindre ces dimensions aussi bien pour des technologies 300 mm que 200 mm.

Par ailleurs, le procédé selon l'invention peut être employé pour réaliser des piliers aux géométries variées. En effet, l'étape d'électro-gravure n'est que très peu voire n'est pas limitante en matière de définition de la forme des piliers.

Un autre avantage du procédé selon la présente invention est qu'il est possible d'exploiter des différences de dopages pour créer simultanément des structures de tailles différentes, que l'on souhaite fabriquer des structures de dimensions toutes inférieures à 100 nm ou bien certaines inférieures et certaines supérieures à 100 nm. Des structures de formes et dimensions variées peuvent ainsi coexister sur le substrat en fin de procédé.

L'invention se distingue notamment de solutions proposées dans l'art antérieur pour la réalisation de réseaux de micro-tiges de silicium dotées de nano-pointes. Un exemple est décrit par Yaghootkar Bahareh et al dans l'article « Promising method toward realization of ultra-low-cost silicon microrod array with nanotip », JOURNAL OF VACUUM SCIENCE, 2020. Il est proposé dans ce document de réaliser une texturation en structures pyramidales de la surface d'un substrat, puis de réaliser une gravure électrochimique pour creuser entre les structures pyramidales et ainsi former des microtiges verticales dont le haut est en forme de pointe. Dans cette solution, l'étape de texturation ne grave le substrat que sur une faible profondeur, et c'est la gravure électrochimique qui définit en grande majorité la dimension verticale des micro-tiges. La gravure électrochimique sert par ailleurs dans cette solution à définir les dimensions latérales des micro-tiges. Cette double fonction de la gravure électrochimique induit un mauvais contrôle des dimensions des micro-tiges, car il est complexe voire impossible lors d'une même étape de gravure de parvenir simultanément, avec précision, à la hauteur souhaitée et aux dimensions latérales souhaitées pour les micro-tiges. Dans le cadre de la présente invention, la gravure anisotrope permet de conférer une hauteur précise à chaque pilier, qui sera également sensiblement la hauteur des piliers. L'électro-gravure quant à elle permet de réduire les dimensions latérales des plots jusqu'à arriver précisément aux dimensions latérales souhaitées pour les piliers.

Par ailleurs, dans cet article de l'art antérieur, lors de la texturation de la surface du substrat sous forme de structures pyramidales, la hauteur de ces dernières dépend des plans cristallins du matériau gravé. Cela induit là aussi une incertitude et un manque de contrôle sur la hauteur finale des micro-tiges.

En outre, le sommet pyramidal des pointes peut avoir un effet optique négatif, à la fois sur l'étape de gravure subséquente et plus généralement dans les applications visées. Cette solution de l'art antérieur n'est donc pas applicable pour toutes les applications. Dans le procédé selon l'invention, les sommets des plots sont plans et leurs flancs verticaux, ce qui est plus avantageux.

Enfin, il est complexe dans le cadre de cette solution de l'art antérieur de réaliser des piliers de différentes dimensions les uns à côté des autres. Cela est permis et facilité par le procédé selon l'invention.

Un deuxième aspect de l'invention concerne un procédé pour la fabrication d'un composant microélectronique mettant en œuvre le procédé selon le premier aspect de l'invention, dans lequel le pilier est destiné à former une diode.

Un troisième aspect de l'invention concerne un procédé pour la fabrication d'un composant microélectronique mettant en œuvre le procédé selon le premier aspect de l'invention, dans lequel le pilier est destiné à former un élément optique pris parmi : une structure d'extraction, une métasurface optique, un cristal photonique, élément diffractif.

Les avantages procurés par le procédé selon le premier aspect de l'invention s'appliquent mutatis mutandis aux procédés selon les deuxième et troisième aspects de l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1E illustrent les étapes d'un mode de réalisation procédé selon l'invention.
Les figures 2A à 2C illustrent différentes géométries pouvant être mises en œuvre pour le pilier obtenu en fin de procédé selon l'invention.
La figure 3 est un graphique schématique illustrant les trois régions de fonctionnement lorsqu'un matériau d'étude est plongé dans une solution électrolytique et qu'un potentiel est imposé entre ce matériau et une contre-électrode.
Les figures 4A et 4B illustrent un mode de réalisation dans lequel des plots sont dopés selon des taux distincts, permettant la formation de piliers aux dimensions caractéristiques distinctes.
Les figures 5A et 5B sont des résultats de simulations illustrant la transmission et le déphasage d'une méta-surface en fonction du diamètre des structures la formant.
Les figures 6A à 6C illustrent un mode de réalisation dans lequel un masque dur est déposé sur le substrat et dans lequel on confère à ce masque dur les dimensions latérales plot et on les lui fait conserver lors de la transformation du plot en pilier.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple préféré, S₁₀₀₀≤0,75*S₁₀₀, de préférence S₁₀₀₀≤0,5*S₁₀₀, de préférence S₁₀₀₀<0,25*S₄₁₀₀. De préférence, dans tous les plans parallèles au plan principal et passant par le plot puis par le pilier, on a S₄₀₀₀<S₄₀₀, de préférence S₁₀₀₀≤0,75*S₁₀₀, de préférence S₁₀₀₀≤0,5*S₁₀₀, de préférence S₁₀₀₀≤0,25*S₁₀₀.

Selon un exemple préféré, l'au moins un plot présente en projection dans le plan principal une dimension caractéristique L₁₀₀ avec L₁₀₀≥80 nm, de préférence L₁₀₀≥100 nm.

Selon un exemple préféré, L₁₀₀≤1 µm.

Selon un exemple préféré, l'au moins un pilier présente en projection dans le plan principal une dimension caractéristique L₁₀₀₀ avec L₁₀₀₀≤50 nm, de préférence L₁₀₀₀≤30 nm.

Selon un exemple préféré, en projection dans le plan principal, l'au moins un plot présente une dimension caractéristique L₁₀₀ et l"au moins un pilier une dimension caractéristique L₁₀₀₀, avec L₁₀₀₀≤0,75*L₁₀₀, de préférence L₁₀₀₀<0,5*L₁₀₀, de préférence L₁₀₀₀≤0,25*L₁₀₀. De préférence, dans tous les plans parallèles au plan principal et passant par le plot puis par le pilier, on a L₁₀₀₀≤0,75*L₁₀₀, de préférence L₁₀₀₀≤0,5*L₁₀₀, de préférence L₁₀₀₀≤0,25*L₁₀₀.

Selon un exemple préféré, le substrat est dopé selon un dopage non uniforme et la gravure du substrat est configurée pour former une pluralité de plots dans le substrat, au moins un premier plot et un deuxième plot de la pluralité de plots étant formés dans des régions du substrat présentant des dopages distincts, de sorte que l'étape d'électro-gravure du premier plot et du deuxième plot résulte en la formation d'un premier pilier et d'un deuxième pilier présentant respectivement, en projection dans le plan principal, une deuxième surface S_{1000,a} et S_{1000,b} telles que S_{1000,a} ≠S_{1000,b}. De préférence, après l'étape de gravure et avant l'étape d'électro-gravure, les plots présentent des surfaces S₁₀₀ₐ, S_{100b} distinctes.

Selon un exemple préféré, le substrat présente une région non dopée et une région dopée, éventuellement de façon non uniforme, et la gravure du substrat est configurée pour former une pluralité de plots dans le substrat, au moins un premier plot de la pluralité de plots étant formé dans la région non dopée et au moins un deuxième plot de la pluralité de plots étant formé dans la région dopée. L'électro-gravure sera alors effective sur le deuxième plot mais pas au niveau du premier plot. Le premier plot restera donc intact après l'étape d'électro-gravure. Dans cet exemple, on a donc S₁₀₀ₐ=S₁₀₀₀ₐ et S₁₀₀₀ₐ≠S_{1000b}. De préférence, après l'étape de gravure et avant l'étape d'électro-gravure, les plots présentent surfaces S₁₀₀ₐ, S_{100b} égales.

Selon un exemple préféré, l'étape de gravure comprend :
- la réalisation d'un masque sur la face supérieure du substrat, le masque comprenant des ouvertures,
l'étape d'électro-gravure étant réalisée en présence du masque.

Selon un exemple préféré, l'étape de gravure comprend :
- la réalisation d'un masque sur la face supérieure du substrat, le masque (20) comprenant des ouvertures,
l'étape d'électro-gravure étant réalisée après une étape de retrait du masque.

Selon un exemple, l'étape de gravure comprend en outre, avant la réalisation du masque, une réalisation d'un masque dur sur la face supérieure du substrat, le masque étant ensuite déposé sur le masque dur. La gravure anisotrope est configurée pour graver le masque dur et lui conférer une surface, en projection dans le plan principal, égale à la première surface S₁₀₀, et le masque dur est configuré pour conserver sa surface égale à S₁₀₀ durant l'électro-gravure.

Selon un exemple préféré, le substrat est à base d'un matériau semiconducteur, par exemple choisi parmi les matériaux suivants : Ge, Si, InP, GaN, InGaN, AlGaN.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

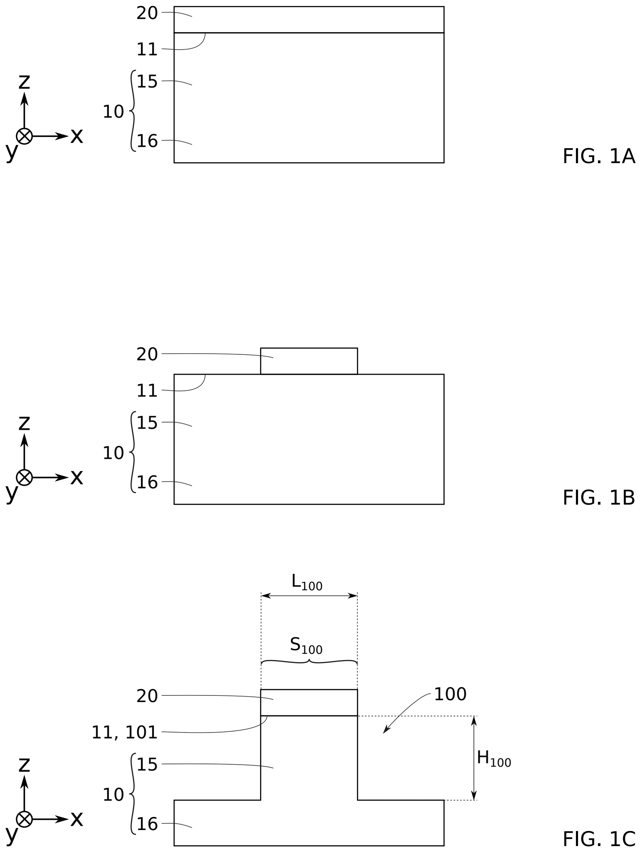

Un repère, de préférence orthonormé, comprenant les axes X, Y, Z est représenté en figure 1A.

Dans la présente demande de brevet, on parlera préférentiellement d'épaisseur pour une couche et de hauteur pour une structure ou un dispositif. La hauteur est prise perpendiculairement au plan principal XY. L'épaisseur est prise selon une direction normale au plan d'extension principal de la couche. Ainsi, une couche présente typiquement une épaisseur selon Z, lorsqu'elle s'étend principalement le long du plan principal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient « à 10% près, de préférence à 5% près ».

Le procédé selon l'invention va maintenant être décrit en détails en référence aux figures 1A à 1D.

Une première étape du procédé comprend la fourniture d'un substrat 10 à base d'un matériau semiconducteur. Ce substrat 10 présente une face supérieure 11 s'étendant principalement parallèlement à un plan principal XY. Le plan principal XY est défini par une première direction X et une deuxième direction Y. Le plan principal XY est perpendiculaire à une troisième direction Z, également désignée direction verticale Z.

Le substrat 10 est à base d'un matériau permettant sa gravure par électro-gravure. Ce matériau peut notamment être un semi-conducteur, en particulier un nitrure ou un phosphure. Il peut par exemple être choisi parmi la liste suivante : GaN, Ge, Si, InP, InGaN, AlGaN.

Comme évoqué en introduction, une des applications avantageuses de la présente invention est celle des métasurfaces optiques, pour lesquelles la matière doit être structurée à une échelle inférieure à la longueur d'onde de travail et ce dans des matériaux à fort indice de réfraction et sans pertes par absorption. Dans ce cadre, lorsque la longueur d'onde de travail se situe dans l'infrarouge, des matériaux d'intérêt pour le substrat 10 sont le silicium (Si) et le germanium (Ge). Lorsque la longueur d'onde de travail se situe dans le spectre visible, un matériau d'intérêt est le GaN.

Le substrat 10 peut également être dopé. Ce mode de réalisation et ses différentes variantes sera décrit plus avant.

Une deuxième étape du procédé selon l'invention comprend une gravure du substrat 10 à partir de sa face supérieure 11. Pour ce faire, il est possible d'employer une technique classique de dépôt d'un masque 20, typiquement une couche de résine 20, sur la face supérieure 11 du substrat 10 (figure 1A), formation d'un motif dans la résine 20 par un procédé de photolithographie (figure 1B) puis gravure (figure 1C). La gravure est typiquement une gravure anisotrope selon la direction verticale Z, perpendiculaire au plan principal XY.

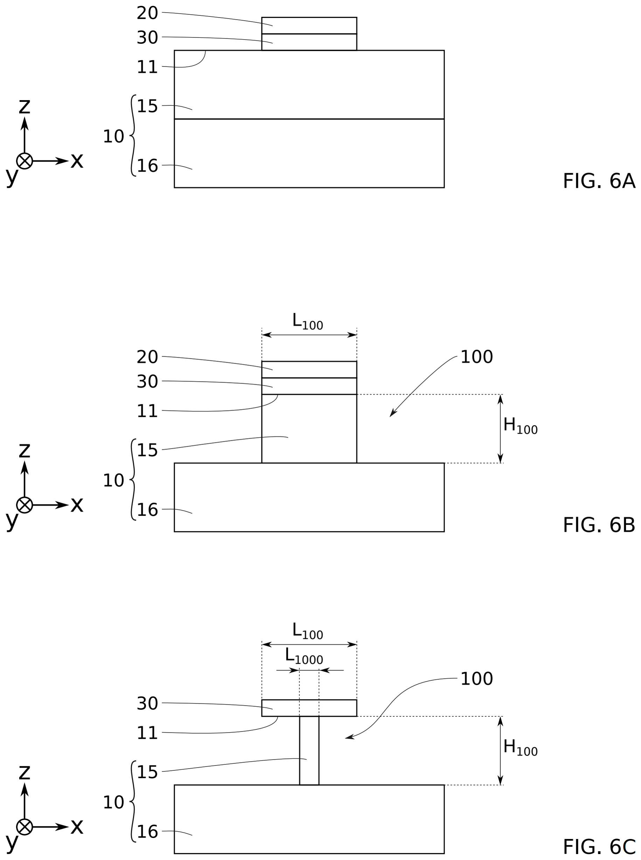

Selon un mode de réalisation particulier, il est possible de déposer un masque dur 30 sur le substrat 10, avant le dépôt de la couche de résine 20. Le masque dur 30 est alors intercalé entre le substrat 10 et la couche de résine 20 et se trouve protégé par la couche de résine 20. Le masque dur 30 est avantageusement à base d'un matériau sensible à la gravure anisotrope, mais insensible à l'électro-gravure qui sera décrite plus avant. Le masque dur 30 peut notamment être à base de SiO₂. La figure 6A illustre l'ensemble obtenu après définition des motifs dans la couche de résine 20 et dans le masque dur 30, avant la gravure et la formation du plot 100.

L'étape de gravure est configurée pour former un plot 100 dans le substrat 10. Le plot 100 présente, en projection dans la plan principal XY, une première surface S₁₀₀. Le plot 100 peut être de diverses formes. Il peut par exemple présenter une forme circulaire, hexagonale ou rectangulaire voire carrée en projection dans le plan principal XY. De préférence, la forme du plot 100 est sensiblement constante le long de la troisième direction Z. Ainsi, comme illustré en figure 1C, les flancs du plot 100 sont de préférence verticaux, c'est-à-dire parallèle à la direction verticale Z. Cela est notamment permis par le caractère anisotrope de la gravure.

De préférence, le plot 100 présente une face supérieure 101 ou sommet 101 plan, c'est-à-dire parallèle au plan principal XY. Avantageusement, le sommet 101 du plot 100 et ses flancs forment des angles droits. Plus généralement, avantageusement, le sommet 101 du plot 100 et les lignes génératrices de ses flancs forment des angles droits. Autrement dit, de préférence, le sommet 101 du plot 100 n'est pas incliné par rapport à un plan parallèle au plan principal XY et n'est notamment pas de forme pyramidale.

Le plot 100 présente une hauteur H₁₀₀ selon la direction verticale Z. La valeur désirée de la hauteur H₁₀₀ est obtenue en paramétrant la gravure anisotrope. La hauteur du futur pilier 1000 est sensiblement égale à H₁₀₀. Ainsi, le dimensionnement de H₁₀₀ est réalisé en fonction de la hauteur souhaitée pour le pilier final. La gravure anisotrope définit ainsi la hauteur du pilier 1000.

Le plot 100 présente une dimension caractéristique L₁₀₀ en projection dans le plan principal XY. Cette dimension caractéristique L₁₀₀ correspond typiquement à la dimension maximale du plot 100 prise dans un plan parallèle au plan principal XY. Lorsque le plot 100 présente une forme circulaire ou sensiblement circulaire en projection dans le plan XY, L₁₀₀ correspond typiquement au diamètre du plot dans le plan XY. Lorsque le plot 100 présente une forme rectangulaire en projection dans le plan XY, L₁₀₀ correspond typiquement au plus long côté de ce rectangle dans le plan XY.

La dimension caractéristique L₁₀₀ ne peut descendre en-deçà des limites qu'offrent les techniques actuelles de photolithographie et gravure. Ces limites sont notamment dépendantes des équipements utilisés et de la nature de la résine employée pour l'étape de photolithographie.

Ainsi, la dimension caractéristique L₁₀₀ est typiquement de l'ordre de quelques centaines de nanomètres. Des équipements avancés de gravure et de photolithographie peuvent permettre que L₁₀₀ soit de l'ordre de la centaine de nanomètre, voire un peu en dessous (environ jusqu'à 80 nm). Des dimensions de l'ordre de 10 nm ou 50 nm ne sont pas envisageables.

La figure 6B illustre l'ensemble obtenu après la formation du plot 100 dans le mode de réalisation particulier où un masque dur 30 a été intercalé entre le substrat 10 et la couche de résine 20. A ce stade, le masque dur 30 présente la même dimension caractéristique L₁₀₀ que le plot 100 sous-jacent.

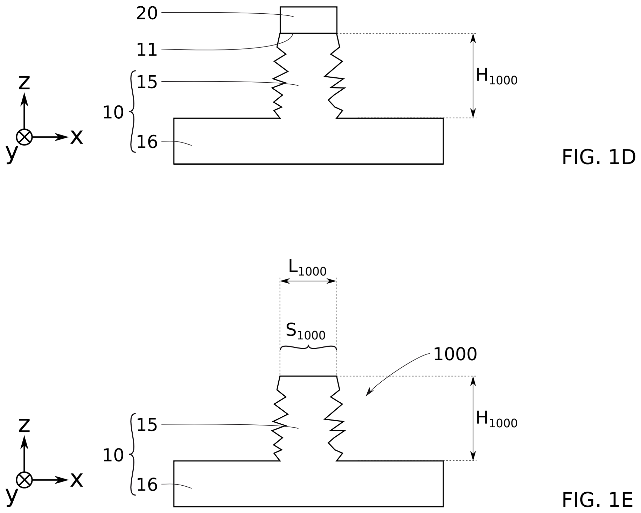

Une troisième étape du procédé selon l'invention comprend une électro-gravure du plot 100. Cette électro-gravure permet de forme un pilier 1000 (figure 1D).

Le pilier 1000 présente, en projection dans la plan principal XY, une deuxième surface S₁₀₀₀. Par voie de fabrication, la deuxième surface S₁₀₀₀ est inférieure à la première surface S₁₀₀. L'électro-gravure est ainsi configurée pour modifier les dimensions latérales du plot et les porter aux dimensions latérales souhaitées pour le pilier. L'électro-gravure est donc principalement une gravure latérale, c'est-à-dire agissant perpendiculairement aux flancs du plot 100. Autrement dit, l'électro-gravure agit principalement parallèlement au plan principal XY.

Le pilier 1000 peut être de diverses formes. Il peut par exemple présenter une forme circulaire ou rectangulaire voire carrée en projection dans le plan principal XY. De préférence, la forme du pilier 1000 est sensiblement constante le long de la troisième direction Z.

Le pilier 1000 présente une dimension caractéristique L₁₀₀₀ en projection dans le plan principal XY. Cette dimension caractéristique L₁₀₀₀ correspond typiquement à la dimension maximale du pilier 1000 prise dans un plan parallèle au plan principal XY. Lorsque le pilier 1000 présente une forme circulaire ou sensiblement circulaire en projection dans le plan XY, L₁₀₀₀ correspond typiquement au diamètre du pilier 1000 dans le plan XY. Lorsque le pilier 1000 présente une forme rectangulaire en projection dans le plan XY, L₁₀₀₀ correspond typiquement au plus long côté de ce rectangle dans le plan XY.

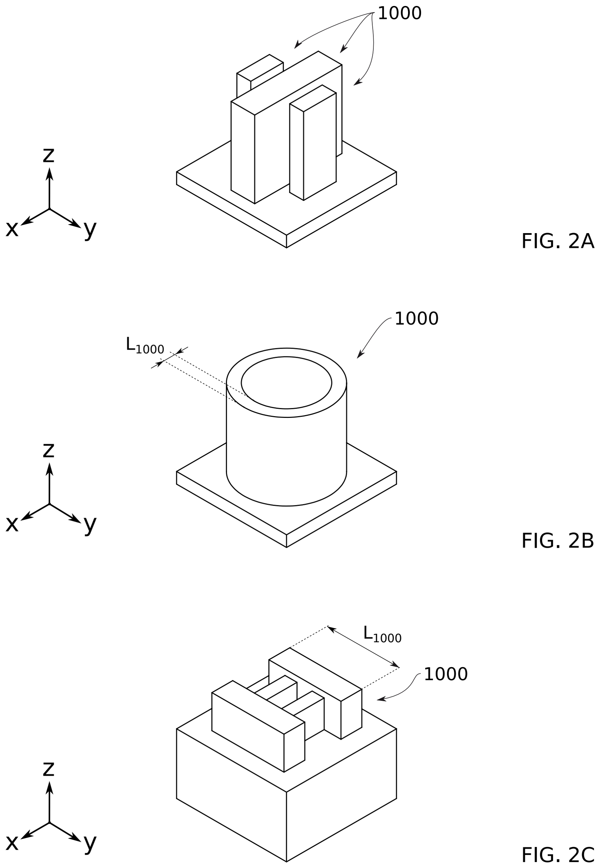

Les figures 2A à 2C illustrent des formes pouvant être prise par le pilier 1000 (ou des ensembles de piliers 1000). La figure 2A par exemple illustre trois piliers 1000 présentant chacun une forme rectangulaire. La figure 2B illustre un pilier 1000 présentant en projection dans le plan principal XY une forme de couronne. La dimension caractéristique L₁₀₀₀ du pilier 1000 correspond dans ce cas à la différence entre le rayon extérieur et le rayon intérieur de la couronne. La figure 2C illustre un pilier 1000 présentant une forme complexe. Le pilier 1000 présente une forme générale en « H », deux parois principales étant reliées par deux parois perpendiculaires de dimensions inférieures. La dimension caractéristique L₁₀₀₀ du pilier 1000 correspond dans ce cas à la longueur des parois principales.

Les piliers 1000 illustrés aux figures 2A, 2B et 2C sont des microstructures - ou méta-atomes - pouvant être utilisés pour créer des méta-surfaces aux propriétés optiques diverses (filtrage, focalisation, collimation, extraction, réseau de diffraction...).

Il est entendu que les exemples de formes pour le pilier 1000 décrits ci-dessus sont donnés à titre non-limitatif. Une infinité de géométrie est envisageable et peut être obtenue par le procédé selon l'invention.

Les paragraphes suivants visent à décrire la mise en œuvre de l'étape d'électro-gravure.

Cette étape peut être réalisées selon les sous-étapes suivantes :
- relier électriquement le substrat 10 et une contre-électrode à un générateur de tension ou de courant,
- plonger le substrat 10 et la contre-électrode dans une solution électrolytique,
- appliquer une tension ou un courant entre le substrat 10 et la contre-électrode de manière à provoquer

La contre-électrode est en un matériau électriquement conducteur, comme par exemple un métal tel que le platine.

Les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, HNO₃, NaNO₃, H₂SO₄ Ou encore un mélange d'acide oxalique et de NaNO₃.

La tension appliquée est fonction du taux de dopage du matériau et peut aller de 1 à 100V. Elle est appliquée, par exemple, pendant une durée allant de quelques millisecondes à plusieurs dizaines de minutes. La durée de l'application de la tension ou du courant dépend des dimensions que l'on souhaite conférer au pilier 1000 en fin de procédé. Plus l'on souhaite que la deuxième surface S₁₀₀₀ du pilier 1000 soit réduite, plus la durée d'application sera élevée.

De préférence, l'étape d'électro-gravure est appliquée uniformément sur le substrat. Les paramètres de l'étape d'électro-gravure, en particulier la tension appliquée, sont appliqués uniformément sur le substrat.

L'étape d'électro-gravure employée dans le procédé selon la présente invention se différencie d'une étape d'électro-polissage telle qu'entendue dans le domaine particulier de l'électrochimie. Le but de l'électro-polissage est de rendre une surface la plus lisse possible. Dans ce type de procédé, un composé est déposé sur la surface rugueuse à polir et vient se loger dans les vallées définies par la rugosité de surface. Ce composé empêche localement, au niveau des vallées, la réaction électrochimique. Les pics séparant les vallées comblées par le composant sont eux gravés par la réaction électrochimique. Cela permet une diminution de la rugosité de la surface, et conduit donc à une surface quasi-lisse voire lisse. Ce procédé diffère complètement de l'étape d'électro-gravure employée dans la présente invention. L'objectif de l'étape d'électro-gravure dans la présente invention est de réduire les dimensions du plot 100 pour arriver au pilier 1000.

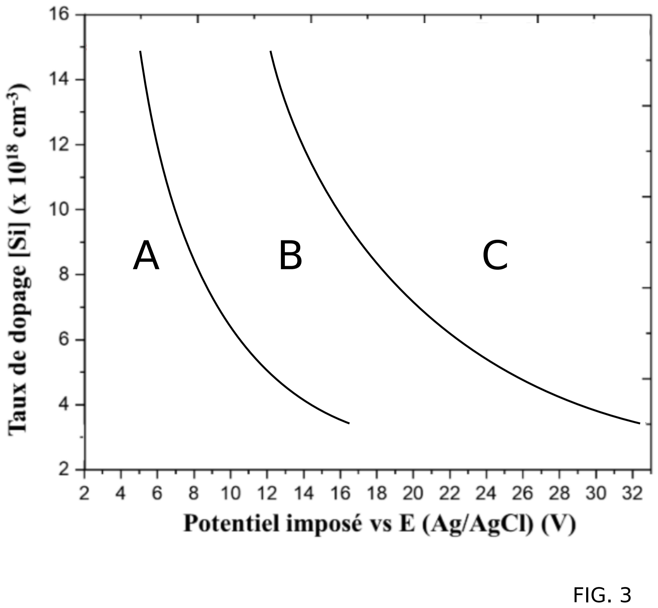

L'étape d'électro-gravure employée dans le procédé selon la présente invention se différencie également d'une étape d'électro-porosification, qui s'effectue dans un domaine de potentiel imposé et de taux de dopage du matériau porosifié/gravé différent. La figure 3 est un graphique schématique illustrant l'existence de trois régions principales de fonctionnement lorsqu'un matériau d'étude est plongé dans une solution électrolytique et qu'un potentiel est imposé entre ce matériau et une contre-électrode. La région référencée A sur le graphique correspond à des couples de taux de dopage et de potentiels imposés pour lesquels le matériau n'est pas ou très peu altéré. La région A est désignée région de pré-porosification ou « pre-breakdown ». La région B correspond à des conditions dans lesquelles le matériau subit une porosification lors de l'application de la tension. La région C correspond à la région de gravure du matériau. L'étape d'électro-gravure mise en œuvre dans le procédé selon la présente invention se trouve dans cette région C.

Selon un premier mode de réalisation, la couche de résine 20 est conservée lors de l'étape d'électro-gravure. La couche de résine 20 protège ainsi la face supérieure 101 du plot 100 lors de l'électro-gravure. C'est ce mode de réalisation qui est illustré par l'enchaînement des figures 1C à 1E. La présence de la couche de résine 20 sur le plot 100 lors de l'électro-gravure permet d'empêcher que l'électro-gravure ne vienne retirer de la matière par la face supérieure 101 du plot 100. Ainsi, dans ce mode de réalisation, la hauteur H₁₀₀₀ du pilier 1000 est égale à la hauteur H₁₀₀ du plot 100. La couche de résine 20 est de préférence retirée après l'électro-gravure (figure 1E). Au lieu de la couche de résine 20 ou en combinaison avec celle-ci, il est également possible d'employer un masque dur en matériau diélectrique (ex : SiO₂) pour protéger la face supérieure 101 du plot 100 lors de l'étape d'électro-gravure. Il est également possible qu'une portion supérieure de plot 100, s'étendant de préférence depuis sa face supérieure 101, soit très peu voire non dopée, afin de limiter l'impact de l'électro-gravure dans cette région.

Selon un autre mode de réalisation non illustré, la couche de résine 20 est retirée avant l'étape d'électro-gravure. Dans ce mode de réalisation, l'électro-gravure permet de conférer au pilier 1000 une hauteur H₁₀₀₀ inférieure à la hauteur H₁₀₀ du plot 100. Cela peut être souhaité dans certaines applications où la dimension en hauteur se doit d'être très petite.

Dans le mode de réalisation particulier où un masque dur 30 a été déposé sur le substrat 10 avant la couche de résine 20, le masque dur 30 n'est pas électro-gravé lors de cette étape. On obtient ainsi l'ensemble illustré en figure 6C. Le masque dur 30 a conservé sa dimension caractéristique L₁₀₀ tandis que le pilier 1000 sous-jacent présente une dimension caractéristique L₁₀₀₀, inférieure à L₁₀₀. Ainsi, le masque dur 30 s'étend au-delà du pilier 1000 sous-jacent en projection dans le plan principal XY.

Le procédé selon l'invention a jusqu'ici été présenté pour un seul plot 100 puis un seul pilier 1000, mais il est entendu qu'il peut être mis en oeuvre pour fabriquer une pluralité de piliers 1000.

Comme indiqué plus haut, le substrat 10 peut être dopé. Le dopage du substrat 10 peut notamment être configuré en fonction des dimensions et de la forme désirées pour les piliers 1000.

Avantageusement, le dopage du substrat 10 n'est pas uniforme.

Tout d'abord, le dopage du substrat 10 peut varier selon la troisième direction Z. Notamment, le substrat 10 peut être un bicouche et comprendre une première couche 15 présentant un dopage D₁ et une deuxième couche 16 présentant un dopage D₀. L'étape de gravure est alors avantageusement configurée pour que la gravure s'arrête à l'interface entre la première couche 15 et la deuxième couche 16. Le plot 100 est alors formé par la première couche 15 (voir figure 1C). En conférant un dopage D₁ à la première couche 15 supérieur au dopage D₀ de la deuxième couche 16, on s'assure que l'électro-gravure se concentre sur le plot 100. Avantageusement, le dopage D₀ est choisi pour que la deuxième couche 16 soit très peu gravée, voire ne soit pas gravée du tout, lors de l'étape d'électro-gravure.

En particulier, les dopages D₁ et D₀ pourront être choisis à partir d'un « abaque » tel que celui illustré à la figure 3. Un tel « abaque » permet de définir les taux de dopage respectifs pour qu'à potentiel donné, il y ait une sélectivité entre la première couche, fortement dopée, et la deuxième douche, faiblement dopée. Pour un potentiel donné :
- le taux de dopage de la deuxième couche 16 doit se situer de préférence dans la région A ou éventuellement dans la zone B pour que la deuxième couche 16 ne soit pas électro-gravée lors de l'étape d'électro-gravure. Dans le cas où le taux de dopage de la deuxième couche 16 se situe dans la région B, une couche protectrice peut éventuellement être déposée sur la deuxième couche 16, entre les piliers, pour éviter qu'elle soit porosifiée au cours de l'étape d'électro-gravure.
- le taux de dopage de la première couche 15 doit situer dans la région C pour que la première couche 15 soit gravée lors de l'étape d'électro-gravure.

Par exemple, en fixant le potentiel à 15V, on peut fixer un taux de dopage D₀ de la première couche 15 supérieur ou égal à 1,2^{e}19 at/cm³et un taux de dopage D1 de la deuxième couche 16 inférieur ou égal à 3^{e}18 at/cm³.

Le substrat 10 peut également être un tricouche. Une troisième couche peut par ailleurs être intercalée entre la première couche 15 et la deuxième couche 16. La troisième couche est de préférence peu ou pas dopée. Son dopage est ainsi de préférence strictement inférieur à D₀ et à D₁. La troisième couche présente par exemple un dopage inférieur à 5.10¹⁷ at/cm³. La présence de cette troisième couche pas ou peu dopée permet de limiter voire d'éviter la gravure de la deuxième couche 16 qui conduit les électrons.

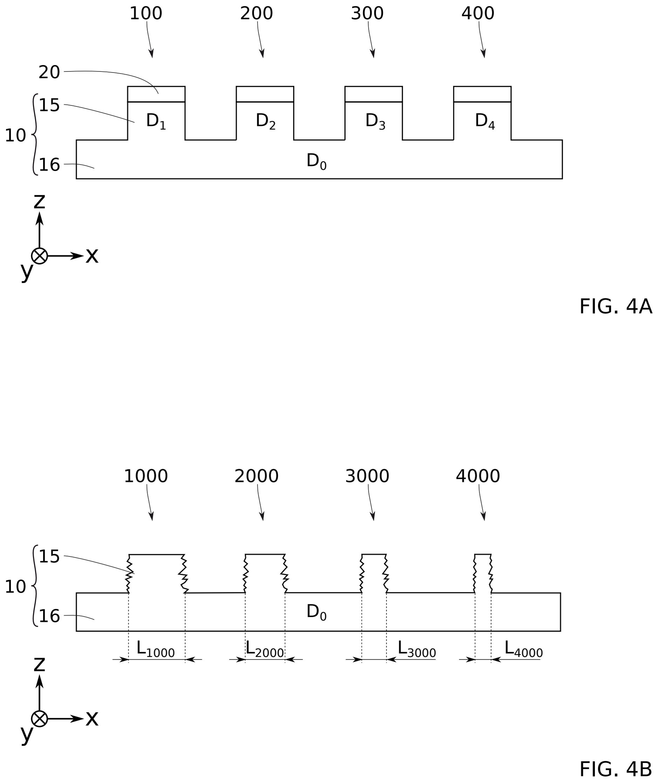

Par ailleurs, le dopage du substrat 10 peut varier selon les première et deuxième directions X, Y. Notamment, le dopage du substrat 10 peut être configuré pour qu'après l'étape de gravure et de formation des plots, au moins certains de ces plots présentent des dopages distincts. Par exemple, la figure 4A illustre un ensemble de quatre plots 100, 200, 300, 400, chacun présentant un dopage distinct D₁, D₂, D₃, D₄, avec D₁<D₂<D₃<D₄. Lors de l'étape d'électro-gravure, à un potentiel donné, plus un plot est dopé, plus celui-ci est gravé. Ainsi, les piliers 1000, 2000, 3000, 4000 obtenus après l'étape d'électro-gravure (figure 4B) présentent des dimensions caractéristiques distinctes, ici décroissantes: L₁₀₀₀<L₂₀₀₀<L₃₀₀₀<L₄₀₀₀.

Il est par ailleurs possible que certaines zones du substrat 10 soient exemptes de dopage. Les plots formés dans ces zones ne seront donc pas gravés lors de l'étape d'électro-gravure (dans ce cas, L₁₀₀=L₁₀₀₀).

Ainsi, en réalisant un dopage non uniforme du substrat 10 dans le plan principal XY, il est possible de former des structures de tailles différentes. Cela permet d'avoir un grand nombre de degrés de liberté sur le dimensionnement des microstructures finales et de multiplier les géométries accessibles sur un même substrat, avec la possibilité de faire coexister des structures très petites avec des structures de beaucoup plus grandes dimensions. Grâce au procédé selon l'invention, il est par exemple possible de former sur un même substrat des structures d'une dizaine de nanomètres et des structures de quelques centaines de nanomètres.

Les différents niveaux de dopage au sein du substrat 10 peuvent être obtenus par différents procédés.

Le substrat 10 peut notamment être implanté, par exemple avec du silicium (Si(n)) ou avec du magnésium (Mg(p)). Il est notamment possible de réaliser une implantation inhomogène pour conférer aux futurs plots 100, 200, 300, 400 des taux de dopage distincts.

Le dopage par implantation peut être remplacé par un dopage par épitaxie en phase vapeur aux organométalliques (MOCVD), avec comme dopant Si ou Ge notamment. Il est par exemple possible de réaliser deux étapes d'épitaxie successives avec masquages successifs pour obtenir deux niveaux de dopages différents afin de former le bicouche 15, 16 du substrat 10.

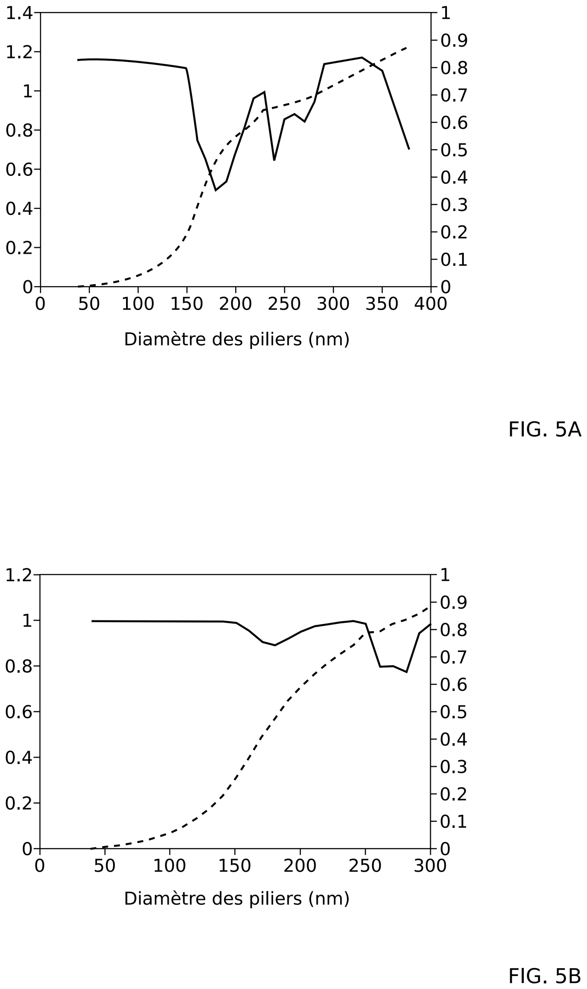

Comme mentionné précédemment, la présente invention trouve comme application particulièrement avantageuse le domaine des méta-surfaces formées d'un ensemble de structures de très petites dimensions. Les figures 5A et 5B illustrent l'intérêt de l'invention dans ce domaine.

Les figures 5A et 5B sont des résultats de simulations illustrant la transmission et le déphasage d'une méta-surface en fonction du diamètre des structures la formant. Le graphique de la figure 5A a été obtenu pour une période de 420 nm entre les structures et la figure 5B pour une période de 340 nm. On observe notamment sur la figure 5A des chutes importantes de la transmission. Ces faibles valeurs de transmission illustrent un problème de résonnances sur certaines géométries, c'est-à-dire notamment pour certains couples période/diamètre. Pour fabriquer une méta-surface de bonne qualité, il faut se placer dans des domaines où la transmission est élevée. Il apparaît que cela est le cas pour de petites valeurs de diamètres. La zone entourée sur la figure 5B correspond par exemple à des valeurs de diamètres qui, pour une période de 340 nm, donnent de très bons résultats. Il s'agit de diamètres compris entre 40 et 100 nm. On comprend donc l'intérêt de l'invention dans ce domaine particulier.

Au regard des différents modes de réalisation décrits ci-dessus, il apparaît que la présente invention permet, en combinant des techniques issues de deux domaines différents, de fabriquer des structures de très petites dimensions. La présente invention permet par ailleurs de former simultanément des structures de dimensions distinctes, et même des structures dont les dimensions sont de différents ordres de grandeur.

La présente invention n'est pas limitée à la fabrication de structures pour des méta-surfaces optiques. Elle peut également être utilisée dans la fabrication de tout dispositif optoélectronique ou microélectronique nécessitant de petites dimensions, comme par exemple une diode ou une lentille.

L'invention n'est pas limitée aux modes de réalisations précédemment décrits et s'étend à tous les modes de réalisation couverts par l'invention.

## Revendications

1. Procédé de fabrication de microstructures comprenant les étapes suivantes :
• Fournir un substrat (10), le substrat (10) présentant une face supérieure (11) s'étendant principalement parallèlement à un plan dit plan principal (XY),
• Réaliser une gravure anisotrope du substrat (10) à partir de sa face supérieure (11) et selon une direction verticale (Z) perpendiculaire au plan principal (XY), de manière à former au moins un plot (100) dans le substrat (10), le plot (100) présentant, en projection dans le plan principal (XY), une première surface S₁₀₀ et une hauteur H₁₀₀ selon la direction verticale (Z),
• Réaliser une électro-gravure de l'au moins un plot (100) de sorte à former un pilier (1000), le pilier (1000) présentant, en projection dans le plan principal (XY), une deuxième surface S₁₀₀₀, avec S₁₀₀₀<S₁₀₀, et une hauteur selon la direction verticale (Z) égale à H₁₀₀.

2. Procédé selon la revendication précédente dans lequel S₁₀₀₀≤0,75*S₁₀₀, de préférence S₁₀₀₀≤0,5*S₁₀₀, de préférence S₁₀₀₀≤0,25*S₁₀₀.

3. Procédé selon l'une quelconque des revendications précédentes dans lequel l'au moins un plot (100) présente en projection dans le plan principal (XY) une dimension caractéristique L₁₀₀ avec L₁₀₀≥80 nm, de préférence L₁₀₀≥100 nm.

4. Procédé selon la revendication précédente dans lequel L₁₀₀≤1µm.

5. Procédé selon l'une quelconque des revendications précédentes dans lequel l'au moins un pilier (1000) présente en projection dans le plan principal (XY) une dimension caractéristique L₁₀₀₀ avec L₁₀₀₀≤50 nm, de préférence L₁₀₀₀≤30 nm.

6. Procédé selon l'une quelconque des revendications précédentes dans lequel, en projection dans le plan principal (XY), l'au moins un plot (100) présente une dimension caractéristique L₁₀₀ et l"au moins un pilier (1000) une dimension caractéristique L₁₀₀₀, avec L₁₀₀₀≤0,75*L₁₀₀, de préférence L₁₀₀₀≤0,5*L₁₀₀, de préférence L₁₀₀₀≤0,25*L₁₀₀.

7. Procédé selon l'une quelconque des revendications précédentes dans lequel le substrat (10) est dopé selon un dopage non uniforme et dans lequel la gravure du substrat (10) est configurée pour former une pluralité de plots (100) dans le substrat (10), au moins un premier plot (100a) et un deuxième plot (100b) de la pluralité de plots (100) étant formés dans des régions du substrat (10) présentant des dopages distincts, de sorte que l'étape d'électro-gravure du premier plot (100a) et du deuxième plot (100b) résulte en la formation d'un premier pilier (1000a) et d'un deuxième pilier (1000b) présentant respectivement, en projection dans le plan principal (XY), une deuxième surface S_{1000,a} et S_{1000,b} telles que S_{1000,a} ≠S_{1000,b}.

8. Procédé selon l'une quelconque des revendications précédentes dans lequel le substrat (10) présente une région non dopée et une région dopée, éventuellement de façon non uniforme, et dans lequel la gravure du substrat (10) est configurée pour former une pluralité de plots (100) dans le substrat (10), au moins un premier plot (100a) de la pluralité de plots (100) étant formé dans la région non dopée et au moins un deuxième plot (100b) de la pluralité de plots (100) étant formé dans la région dopée.

9. Procédé selon l'une quelconque des revendications précédentes dans lequel l'étape de gravure comprend :
• la réalisation d'un masque (20) sur la face supérieure (11) du substrat (10), le masque (20) comprenant des ouvertures,
l'étape d'électro-gravure étant réalisée en présence du masque (20).

10. Procédé selon l'une quelconque des revendications 1 à 8 dans lequel l'étape de gravure comprend :
• la réalisation d'un masque (20) sur la face supérieure (11) du substrat (10), le masque (20) comprenant des ouvertures,
l'étape d'électro-gravure étant réalisée après une étape de retrait du masque (20).

11. Procédé selon l'une quelconque des deux revendications précédentes dans lequel l'étape de gravure comprend en outre :
• avant la réalisation du masque (20), une réalisation d'un masque dur (30) sur la face supérieure (11) du substrat (10),
le masque (20) étant ensuite déposé sur le masque dur (30),
la gravure anisotrope étant configurée pour graver le masque dur (30) et lui conférer une surface, en projection dans le plan principal (XY), égale à la première surface S₁₀₀,
et le masque dur (30) étant configuré pour conserver sa surface égale à S₁₀₀ durant l'électro-gravure.

12. Procédé selon l'une quelconque des revendications précédentes dans lequel le substrat (10) est à base d'un matériau semiconducteur, par exemple choisi parmi les matériaux suivants : Ge, Si, InP, GaN, InGaN, AlGaN.

13. Procédé pour la fabrication d'un composant microélectronique mettant en œuvre le procédé selon l'une quelconque des revendications précédentes, dans lequel le pilier (1000) est destiné à former une diode.

14. Procédé pour la fabrication d'un composant microélectronique mettant en œuvre le procédé selon l'une quelconque des revendications 1 à 12, dans lequel le pilier (1000) est destiné à former un élément optique pris parmi : une structure d'extraction, une métasurface optique, un cristal photonique, élément diffractif.
